# EUROPÄISCHE PATENTANMELDUNG

(11) **EP 1 993 142 A1**
(43) Veröffentlichungstag der Anmeldung: **19.11.2008**
(21) Anmeldenummer: 07009628.4
(22) Anmeldetag: 14.05.2007
(51) Int. Cl.: H01L 31/0216, H01L 31/0232, H01L 31/052

(54) **Reflektiv beschichtetes Halbleiterbauelement, Verfahren zu dessen Herstellung sowie dessen Verwendung**

(71) Anmelder: Fraunhofer-Gesellschaft zur Förderung der angewandten Forschung e.V., 80686 München (DE)
(72) Erfinder: Janz, Stefan, 79106 Freiburg (DE); Reber, Stefan, 79194 Gundelfingen (DE)
(74) Vertreter: Pfenning, Meinig & Partner GbR

(57) **Zusammenfassung**

Die Erfindung betrifft ein reflektiv beschichtetes Halbleiterbauelement, das eine Halbleiterschicht, eine funktionale, im Wesentlichen aus Silicium und Kohlenstoff bestehende Schicht, und mindestens eine weitere, im Wesentlichen aus Silicium und Kohlenstoff bestehende Schicht, aufweist. Diese weitere Schicht fungiert als Reflektor für auf das Halbleiterbauelement fallendes Licht. Ebenso betrifft die Erfindung ein Verfahren zur Herstellung derartiger Halbleiterbauelemente. Verwendung finden die Halbleiterbauelemente insbesondere als Solarzellen bzw. als Bestandteil von Sensoren oder optischen Filtern.

## Beschreibung

Die Erfindung betrifft ein reflektiv beschichtetes Halbleiterbauelement, das eine Halbleiterschicht, eine funktionale, im Wesentlichen aus Silicium und Kohlenstoff bestehende Schicht, und mindestens eine weitere, im Wesentlichen aus Silicium und Kohlenstoff bestehende Schicht, aufweist. Diese weitere Schicht fungiert als Reflektor für auf das Halbleiterbauelement fallendes Licht. Ebenso betrifft die Erfindung ein Verfahren zur Herstellung derartiger Halbleiterbauelemente. Verwendung finden die Halbleiterbauelemente insbesondere als Solarzellen bzw. als Bestandteil von Sensoren oder optischen Filtern.

Bei der Herstellung von hocheffizienten dünnen, kristallinen Silicium-Solarzellen besitzt die Reflexion an der Rückseite der Solarzelle im langwelligen Bereich des Lichtspektrums eine große Bedeutung. Nur wenn es gelingt, den bei der ersten Durchstrahlung der dünnen Zelle noch nicht absorbierten Photonenstrom in sehr hohem Maße zu reflektieren, damit den effektiven Weg des eingestrahlten Lichtes zu verlängern und damit auch das langwelligere Licht zu absorbieren, ist es möglich, das volle Potential der dünnen Solarzellen auszureizen. Je nach Konzept der Solarzelle sind aber neben dieser "spiegelnden" Wirkung der Rückseite auch andere Wirkungsweisen an der Rückseite gefordert. So bedarf es z.B. beim rekristallisierten Wafer-Äquivalent einer Diffusionsbarriere oder bei einer Wafer-basierten Solarzelle einer Oberflächenpassivierung.

Bei den genannten Zellkonzepten wird schon seit einiger Zeit in der Forschung amorphes Siliciumcarbid (SiC) als Diffusionsbarriere oder als Passivierungsschicht eingesetzt. Dieses Material zeichnet sich u.a. dadurch aus, dass es eine extreme Resistenz gegenüber Temperatur und vielen nasschemischen Prozessen besitzt. Des Weiteren wird es in einigen Fällen als Quellschicht für Wasserstoff und/oder Dotierstoffe verwendet. Amorphes SiC ist somit eine vielseitige funktionale Dünnschicht.

In der Photovoltaik gefordert sind Schichten, die die Eigenschaften hohe Reflektivität, elektrische Leitfähigkeit, Oberflächenpassivierung und/oder Diffusionsbarriere miteinander kombinieren. Alle bisher eingesetzten Schichten oder Schichtpakete sind nicht in der Lage, alle diese Eigenschaften optimal zu erfüllen.

Ausgehend hiervon war es Aufgabe der vorliegenden Erfindung, Halbleiterbauelemente bereitzustellen, die entsprechende Schichten mit den genannten Eigenschaften in kombinierter Form aufweisen. Diese Aufgabe wird durch das Halbleiterbauelement mit den Merkmalen des Anspruchs 1, die Verfahren zu dessen Herstellung mit den Merkmalen des Anspruchs 22 und 23 und die Verwendung gemäß den Ansprüchen 27 bis 29 gelöst. Die weiteren abhängigen Ansprüche zeigen vorteilhafte Weiterbildungen auf.

Erfindungsgemäß wird ein reflektiv beschichtetes Halbleiterbauelement bereitgestellt, das eine Halbleiterschicht mit einer einfallendem Licht zugewandten Vorderseite und einer entsprechend gegenüber liegenden Rückseite enthält, wobei die Halbleiterschicht rückseitig eine funktionale Schicht, die im Wesentlichen aus Silicium und Kohlenstoff besteht, sowie einen Reflektor aus mindestens einer weiteren Schicht, die im Wesentlichen aus Silicium und Kohlenstoff besteht, aufweist. Die Brechungsindizes der funktionalen Schicht und des Reflektors, d.h. der mindestens einen Siliciumcarbid-Schicht bzw. im Wesentlichen aus Silicium und Kohlenstoff bestehenden Schicht, unterscheiden sich dabei derart, dass auf das Halbleiterbauelement einfallendes Licht im Wellenlängenbereich größer 500 nm am Reflektor reflektiert wird. Es kann so der effektive Weg des eingestrahlten Lichts in der Halbleiterschicht zumindest verdoppelt werden.

Die Reflektionseigenschaften können dadurch gezielt eingestellt werden, so dass in Abhängigkeit von der Art der funktionalen Schicht und deren Brechungsindex der Brechungsindex bzw. die Brechungsindizes der mindestens einen weiteren Siliciumcarbid-Schicht bzw. der im Wesentlichen aus Silicium und Kohlenstoff bestehenden Schicht eingestellt werden. Entscheidend für die Effektivität der Reflektion sind dabei die Differenzen im Brechungsindex zwischen der funktionalen Schicht und des Reflektors sowie die Dicken der einzelnen Siliciumcarbid-Schichten des Reflektors. Je größer der Unterschied im Brechungsindex ist, desto höher wird die maximale Reflektion. Über die Schichtdicken der einzelnen Siliciumcarbid-Schichten lässt sich der reflektierte Wellenlängenbereich einstellen.

Vorzugsweise reflektiert der Reflektor Licht im Wellenlängenbereich von 500 nm bis 2000 nm. Dabei werden bevorzugt 60 %, besonders bevorzugt 80 % des auf das Halbleiterbauelement einfallenden Lichtes reflektiert.

Vorzugsweise besteht der Reflektor aus einem System mehrerer Siliciumcarbid-Schichten, wobei die Brechungsindizes der einzelnen Schichten so aufeinander abgestimmt sind, dass mindestens 60 %, insbesondere mindestens 80 % des einfallenden Lichts in Wellenlängenbereichen > 500 nm am Reflektor reflektiert wird.

Grundsätzlich können die Brechungsindizes der funktionalen Schicht und der Schichten des Reflektors im Bereich von 1,4 bis 3,8 liegen. Im Falle einer funktionalen Schicht mit einem Brechungsindex von 1,4 ist es somit bevorzugt, einen möglichst hohen Brechungsindex für die benachbarte Siliciumcarbid-Schicht des Reflektors zu wählen, z.B. 3,8. Auf diese Weise lässt sich ein maximaler Reflektionsgrad realisieren. Besteht der Reflektor aus mehreren Siliciumcarbid-Schichten, so können diese gestuft die genannte Brechungsindex-Skala von 1,4 bis 3,8 durchlaufen. Die besten Reflektionswerte erhält man dann, wenn die benachbarten Siliciumcarbid-Schichten einen maximalen Brechungsindexunterschied aufweisen. Alternierende Schichtfolgen mit den Brechungsindex-Grenzwerten 1,4 und 3,8 sind in diesen Fällen somit bevorzugt.

Die mindestens eine Siliciumcarbid-Schicht des Reflektors weist vorzugsweise eine Dicke auf, die einem Viertel der Wellenlänge der zu reflektierenden Strahlung mit der kürzesten Wellenlänge (λₘᵢₙ/4) entspricht. Die mindestens eine Schicht des Reflektors weist somit eine Dicke vorzugsweise im Bereich von 50 nm bis 100 µm auf.

Vorzugsweise besteht die mindestens eine Schicht des Reflektors aus amorphem Siliciumcarbid oder enthält im Wesentlichen amorphes Siliciumcarbid.

Der Kohlenstoffgehalt der Siliciumcarbid-Schicht bzw. der im Wesentlichen aus Silicium und Kohlenstoff bestehenden Schicht liegt vorzugsweise im Bereich von 5 bis 95 At.-%. Bei einem Kohlenstoffgehalt der Siliciumcarbid-Schicht bzw. der im Wesentlichen aus Silicium und Kohlenstoff bestehenden Schicht von 5 At.-% beträgt der Brechungsindex dieser Schicht etwa 3,6, bei einem Kohlenstoffgehalt der Siliciumcarbid-Schicht von 95 At.-% bei etwa 1,7.

Vorzugsweise weist die funktionale Schicht des Halbleiterbauelementes eine Dicke im Bereich von 5 nm bis 1500 µm auf. Die funktionale Schicht besteht dabei vorzugsweise aus amorphem Siliciumcarbid bzw. enthält im Wesentlichen amorphes Siliciumcarbid.

Vorzugsweise ist der Reflektor zumindest bereichsweise auf der Rückseite, also auf der dem Licht abgewandten Seite der funktionalen Seite angeordnet. Ebenso ist es aber auch möglich, dass die funktionale Schicht zumindest bereichsweise auf der Rückseite des Reflektors angeordnet ist.

Die Halbleiterschicht besteht vorzugsweise aus Silicium bzw. enthält im Wesentlichen Silicium. Im Falle von Silicium wird durch den Reflektor vorzugsweise Licht im Wellenlängenbereich von 500 nm bis 1100 nm reflektiert.

Bei einer bevorzugten Ausführungsform des Halbleiterbauelementes handelt es sich hierbei um eine Waferbasierte kristalline Silicium-Solarzelle. In diesem Fall fungiert die funktionale Schicht als Oberflächenpassivierung des Halbleiters. Die funktionale Schicht ist dabei zumindest bereichsweise zwischen Halbleiterschicht und Reflektor angeordnet. Weiterhin weist die Wafer-basierte Solarzelle eine elektrisch kontaktierende Schicht auf, die auf der der funktionalen Schicht abgewandten Seite des Reflektors, d.h. an der freien Rückseite, aufgebracht ist. Diese elektrisch kontaktierende Schicht setzt sich über Unterbrechungen in der funktionalen Schicht und dem Reflektor fort, so dass ein elektrischer Kontakt zur Halbleiterschicht hergestellt wird.

Eine andere bevorzugte Ausführungsform sieht vor, dass das Halbleiterbauelement eine auf einem Waferäquivalent basierende kristalline Silicium-Dünnschichtsolarzelle ist. In diesem Fall weist das Halbleiterbauelement rückseitig ein Substrat auf, wobei hier die funktionale Schicht als Diffusionsbarriere wirkt.

Als Substrate können alle elektrisch leitfähigen Substrate eingesetzt werden. Vorzugsweise ist das Substrat ausgewählt aus der Gruppe bestehend aus kristallinem Silicium, metallischen Blechen und keramischen Materialien. Hierzu zählen z.B. Graphit, Nitrid-basierte Keramiken (TiN, SiN, B) oder Carbidbasierte Keramiken (SiC, BC, TiC).

Eine bevorzugte Ausführungsform des Halbleiterbauelementes weist die folgende Schichtabfolge auf:
1) Halbleiterschicht,
2) funktionale Schicht aus Siliciumcarbid als Diffusionsbarriere,
3) Reflektor aus mindestens einer Siliciumcarbid-Schicht und
4) Substrat.

Eine weitere bevorzugte Ausführungsform des Halbleiterbauelementes weist folgende Schichtabfolge auf:
1) Halbleiterschicht,
2) Reflektor aus mindestens einer Siliciumcarbid-Schicht und
3) funktionale Schicht aus Siliciumcarbid als Diffusionsbarriere,
4) Substrat.

Erfindungsgemäß wird ebenso ein Verfahren zur Herstellung eines reflektiv beschichteten Halbleiterbauelementes, wie es zuvor beschrieben wurde, bereitgestellt, bei dem ein Wafer in eine Reaktionskammer eingebracht wird und mit plasmaunterstützter chemischer Gasphasenabscheidung (PECVD), thermischer CVD oder Sputtern zunächst eine Siliciumcarbid-Schicht als funktionale Schicht und darauf mindestens eine weitere Siliciumcarbid-Schicht als Bestandteil eines Reflektors abgeschieden wird. Dabei werden die Brechungsindizes der funktionalen Schicht und der mindestens einen weiteren Siliciumcarbid-Schicht so aufeinander abgestimmt, dass eine Reflexion von Licht im Wellenlängenbereich größer 500 nm von über 60 % am Reflektor erfolgt.

Erfindungsgemäß wird ebenso ein Verfahren zur Herstellung eines reflektiv beschichteten Halbleiterbauelementes bereitgestellt, bei dem ein Substrat in eine Reaktionskammer eingebracht wird und mittels plasmaunterstützter chemischer Gasphasenabscheidung (PECVD), thermischer CVD oder Sputtern zunächst ein Reflektor aus mindestens einer weiteren Siliciumcarbid-Schicht, auf dem Reflektor eine Siliciumcarbid-Schicht als funktionale Schicht, insbesondere eine Diffusionsbarriere, und auf der funktionalen Schicht eine Halbleiterschicht abgeschieden wird, wobei die Brechungsindizes der funktionalen Schicht und der mindestens einen weitern Schicht des Reflektors so aufeinander abgestimmt werden, dass eine Reflexion von Licht im Wellenlängenbereich größer 500 nm von über 60 % am Reflektor erfolgt.

Vorzugsweise erfolgt vor der Abscheidung eine Plasmareinigung der Oberfläche des Wafers oder dem Substrat.

Für die Abscheidung werden als Prozessgase vorzugsweise Methan (CH₄) und Silan (SiH₄) verwendet. Über die Gasflüsse der Prozessgase CH₄ und SiH₄ kann die Stöchiometrie der Schichten und damit deren Funktion eingestellt werden.

Die Stöchiometrie kann vorzugsweise auch durch weitere Prozessparameter wie Druck, Temperatur und Plasmaleistung eingestellt werden.

Verwendung finden die erfindungsgemäßen Halbleiterbauelemente insbesondere bei der Herstellung von Solarzellen. Ebenso können die Halbleiterbauelemente als Bestandteile von Sensoren oder optischen Filtern eingesetzt werden. Erfindungsgemäß wird ebenso die Verwendung mindestens einer Siliciumcarbid-Schicht als Reflektor in einem Halbleiterbauelement mit mindestens einer Halbleiterschicht und mindestens einer funktionalen Schicht bereitgestellt, wobei die Brechungsindizes der funktionalen Schicht und der mindestens einen Siliciumcarbid-Schicht so aufeinander abgestimmt sind, dass über 60% des Lichts im Wellenlängenbereich größer 500 nm am Halbleiterbauelement reflektiert wird.

Die funktionale Schicht dient dabei vorzugsweise als Oberflächenpassivierung oder Diffusionsbarriere.

Bevorzugt besteht die Siliciumcarbid-Schicht aus amorphem Siliciumcarbid.

Anhand der nachfolgenden Figuren und Beispiele soll der erfindungsgemäße Gegenstand näher erläutert werden, ohne diesen auf die hier gezeigten speziellen Ausführungsformen einschränken zu wollen.

Fig. 1a) zeigt ein aus dem Stand der Technik bekanntes rekristallisiertes Wafer-Äquivalent und

Fig. 1b) zeigt eine Wafer-basierte Solarzelle, wie sie aus dem Stand der Technik bekannt ist.

Fig. 2a) zeigt ein erfindungsgemäßes Wafer-Äquivalent und

Fig. 2b) zeigt eine erfindungsgemäße Wafer-basierte Solarzelle.

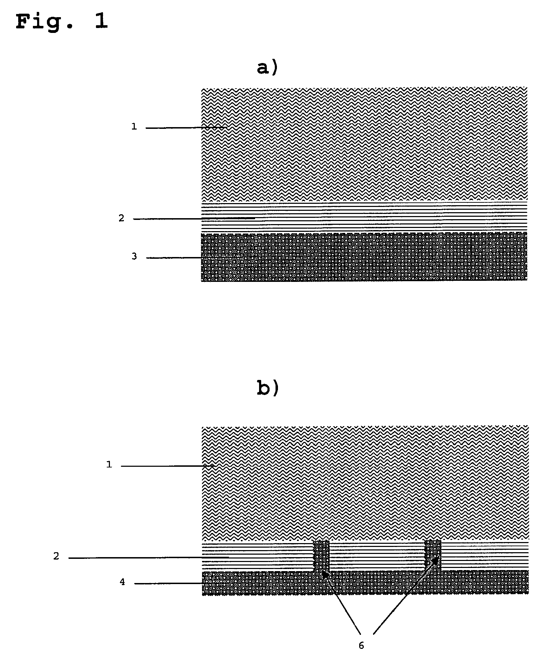

In Fig. 1 ist ein rekristallisiertes Wafer-Äquivalent dargestellt. Hierbei ist auf einem Substrat 3 mit einer funktionalen Schicht aus Siliciumcarbid 2 beschichtet, wobei diese Schicht als Diffusionsbarriere dient. Auf der funktionalen Schicht wiederum ist eine Halbleiterschicht 1 aufgebracht.

In Fig. 1b) ist eine Wafer-basierte Solarzelle mit einer Halbleiterschicht 1, in der Regel Silicium, dargestellt, wobei diese rückseitig mit einer funktionalen Schicht aus Siliciumcarbid 2 beschichtet ist. Auf deren Rückseite wiederum befindet sich eine kontaktierende Schicht 4, wobei sich diese über Kontaktarme 6 durch die funktionale Schicht hindurch bis zur Halbleiterschicht fortsetzt.

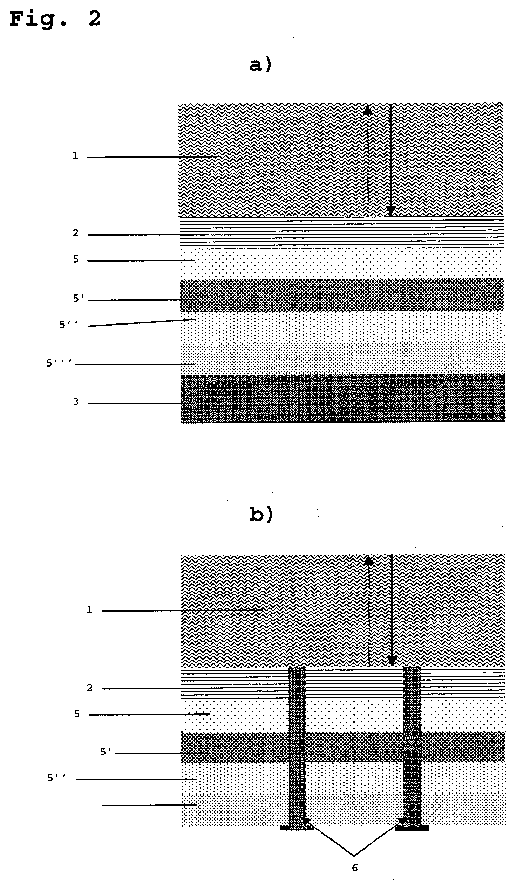

In Fig. 2a) ist der aus dem Stand der Technik bekannte Aufbau eines Wafer-Äquivalents dargestellt, mit einem Substrat 3, auf dem ein Schichtsystem aus mehreren Siliciumcarbid-Schichten unterschiedlicher Stöchiometrie 5 bis 5''' abgeschieden ist, die als Reflektor fungieren. Auf diesem Schichtsystem wird eine funktionale Schicht 2, hier eine Diffusionsbarriere aus Siliciumcarbid, aufgebracht. Auf der funktionalen Schicht ist zusätzlich eine Halbleiterschicht 1 abgeschieden.

In Fig. 2b) ist eine Wafer-basierte Solarzelle dargestellt, mit einer Halbleiterschicht 1 und einer als Oberflächenpassivierung dienenden funktionalen Siliciumcarbid-Schicht 2. Auf deren Rückseite wiederum ist das Schichtsystem aus mehreren Siliciumcarbid-Schichten unterschiedlicher Stöchiometrie 5 bis 5''' aufgebracht. Ebenso sind elektrische Kontakte 6 enthalten.

### Beispiel

### Herstellung einer funktionalen SiC-Schicht kombiniert mit einem Reflektorschichtsystem in einem in-situ-Prozess

- Prozessschritt 1: Die Solarzelle wird in den Plasmareaktor eingeschleust und anschließend auf die gewünschte Temperatur geheizt.
- Prozessschritt 2: Die rückseitige Oberfläche der Solarzelle wird mittels Plasma gereinigt.
- Prozessschritt 3: Direkt im Anschluss wird eine SiC-Schicht mit der Funktion einer Oberflächenpassivierungsschicht abgeschieden.
- Prozessschritt 4: Anschließend werden 5 SiC-Schichten mit den Brechungsindizes 2.5, 1.85, 3.6, 1.85, 2.5 mit einer jeweiligen Schichtdicke von 100 nm abgeschieden. Dabei wird ausschließlich der Methanfluss verändert.

Das Ergebnis dieser Prozessfolge ist eine hervorragend passivierte Rückseite kombiniert mit einem Reflektor der sein Maximum im Bereich zwischen 800 bis 1100 nm Wellenlänge besitzt.

## Patentansprüche

1. Reflektiv beschichtetes Halbleiterbauelement enthaltend eine Halbleiterschicht mit einer einfallendem Licht zugewandten Vorderseite und einer Rückseite, wobei die Halbleiterschicht rückseitig eine funktionale Schicht, die im wesentlichen aus Silicium und Kohlenstoff besteht, und einen Reflektor aus mindestens einer weiteren Schicht, die im Wesentlichen aus Silicium und Kohlenstoff besteht, aufweist, wobei die Brechungsindizes der funktionalen Schicht und des Reflektors so aufeinander abgestimmt sind, dass Licht im Wellenlängenbereich größer 500 nm am Reflektor reflektiert wird.

2. Halbleiterbauelement nach Anspruch 1,
**dadurch gekennzeichnet, dass** der Reflektor Licht im Wellenlängenbereich von 500 nm bis 2500 nm reflektiert.

3. Halbleiterbauelement nach einem der vorhergehenden Ansprüche,
**dadurch gekennzeichnet, dass** über 60 %, insbesondere über 80 % des auf das Halbleiterbauelement einfallenden Lichtes reflektiert wird.

4. Halbleiterbauelement nach einem der vorhergehenden Ansprüche,
**dadurch gekennzeichnet, dass** der Reflektor aus einem System mehrerer Schichten besteht, wobei die Brechungsindizes der einzelnen Schichten so aufeinander abgestimmt sind, dass mehr als 80 % des auf das Halbleiterbauelement einfallenden Lichts im Wellenlängenbereich größer 500 nm reflektiert wird.

5. Halbleiterbauelement nach einem der vorhergehenden Ansprüche,
**dadurch gekennzeichnet, dass** die Brechungsindizes der funktionalen Schicht und der mindestens einen Schicht des Reflektors im Bereich von 1,4 bis 3,8 liegen.

6. Halbleiterbauelement nach einem der vorhergehenden Ansprüche,
**dadurch gekennzeichnet, dass** die mindestens eine Schicht des Reflektors eine optische Dicke aufweist, die λₘᵢₙ/4 der kurzwelligsten zu reflektierenden Strahlung entspricht.

7. Halbleiterbauelement nach einem der vorhergehenden Ansprüche,
**dadurch gekennzeichnet, dass** die mindestens eine Schicht des Reflektors eine Dicke im Bereich von 50 nm bis 100 µm aufweist.

8. Halbleiterbauelement nach einem der vorhergehenden Ansprüche,
**dadurch gekennzeichnet, dass** die mindestens eine Schicht des Reflektors aus amorphem Siliciumcarbid besteht oder dieses im wesentlichen enthält.

9. Halbleiterbauelement nach einem der vorhergehenden Ansprüche,
**dadurch gekennzeichnet, dass** sich benachbarte Schichten des Reflektors in ihrem Kohlenstoffgehalt unterscheiden, wodurch diese Schichten einen unterschiedlichen Brechungsindex aufweisen.

10. Halbleiterbauelement nach einem der vorhergehenden Ansprüche,
**dadurch gekennzeichnet, dass** die funktionale Schicht eine Dicke im Bereich von 5 nm bis 1500 µm aufweist.

11. Halbleiterbauelement nach einem der vorhergehenden Ansprüche,
**dadurch gekennzeichnet, dass** die funktionale Schicht aus amorphem Siliciumcarbid besteht oder dieses im Wesentlichen enthält.

12. Halbleiterbauelement nach einem der vorhergehenden Ansprüche,
**dadurch gekennzeichnet, dass** die Halbleiterschicht aus Silicium besteht oder dieses im Wesentlichen enthält.

13. Halbleiterbauelement nach dem vorhergehenden Anspruch,
**dadurch gekennzeichnet, dass** der Reflektor Licht im Wellenlängenbereich von 500 nm bis 1100 nm reflektiert.

14. Halbleiterbauelement nach einem der vorhergehenden Ansprüche,
**dadurch gekennzeichnet, dass** das Halbleiterbauelement eine waferbasierte kristalline Silicium-Solarzelle ist und die funktionale Schicht als Oberflächenpassivierung fungiert.

15. Halbleiterbauelement nach Anspruch 14,
**dadurch gekennzeichnet, dass** die funktionale Schicht zumindest bereichsweise zwischen Halbleiterschicht und Reflektor angeordnet ist.

16. Halbleiterbauelement nach Anspruch 15,
**dadurch gekennzeichnet, dass** auf der der funktionalen Schicht abgewandten Seite des Reflektors zumindest bereichsweise eine elektrisch kontaktierende Schicht aufgebracht ist, die den elektrischen Kontakt zur Halbleiterschicht herstellt.

17. Halbleiterbauelement nach einem der Ansprüche 1 bis 13,
**dadurch gekennzeichnet, dass** das Halbleiterbauelement eine auf einem Waferäquivalent basierende kristalline Dünnschicht-Solarzelle ist und das Halbleiterbauelement rückseitig ein Substrat aufweist, wobei die funktionale Schicht als Diffusionsbarriere fungiert.

18. Halbleiterbauelement nach Anspruch 17,
**dadurch gekennzeichnet, dass** das Substrat elektrisch leitfähig ist.

19. Halbleiterbauelement nach Anspruch 18,
**dadurch gekennzeichnet, dass** das Substrat ausgewählt ist aus der Gruppe bestehend aus kristallinem Silicium und keramischen Substraten.

20. Halbleiterbauelement nach einem der Ansprüche 17 bis 19, **gekennzeichnet durch** folgende Schichtabfolge:
1) Halbleiterschicht,
2) funktionale Schicht aus Siliciumcarbid als Diffusionsbarriere,
3) Reflektor aus mindestens einer Siliciumcarbid-Schicht und
4) Substrat.

21. Halbleiterbauelement nach einem der Ansprüche 17 bis 19, **gekennzeichnet durch** folgende Schichtabfolge:
1) Halbleiterschicht,
2) Reflektor aus mindestens einer Siliciumcarbid-Schicht und
3) funktionale Schicht aus Siliciumcarbid als Diffusionsbarriere,
4) Substrat.

22. Verfahren zur Herstellung eines reflektiv beschichteten Halbleiterbauelementes nach einem der vorhergehenden Ansprüche, bei dem ein Wafer in eine Reaktionskammer eingebracht wird und mittels plasmaunterstützter chemischer Gasphasenabscheidung (PECVD), thermischer CVD oder Sputtern zunächst eine Siliciumcarbid-Schicht als funktionale Schicht und darauf ein Reflektor aus mindestens einer weiteren Siliciumcarbid-Schicht abgeschieden wird, wobei die Brechungsindizes der funktionalen Schicht und der mindestens einen weiteren Schicht des Reflektors so aufeinander abgestimmt werden, dass eine Reflexion von Licht im Wellenlängenbereich größer 500 nm von über 60 % am Reflektor erfolgt.

23. Verfahren zur Herstellung eines reflektiv beschichteten Halbleiterbauelementes nach einem der vorhergehenden Ansprüche, bei dem ein Substrat in eine Reaktionskammer eingebracht wird und mittels plasmaunterstützter chemischer Gasphasenabscheidung (PECVD), thermischer CVD oder Sputtern zunächst ein Reflektor aus mindestens einer weiteren Siliciumcarbid-Schicht, auf dem Reflektor eine Siliciumcarbid-Schicht als funktionale Schicht und auf der funktionalen Schicht eine Halbleiterschicht abgeschieden wird, wobei die Brechungsindizes der funktionalen Schicht und der mindestens einen weiteren Schicht des Reflektors so aufeinander abgestimmt werden, dass eine Reflexion von Licht im Wellenlängenbereich größer 500 nm von über 60 % am Reflektor erfolgt.

24. Verfahren nach Anspruch 22 oder 23,
**dadurch gekennzeichnet, dass** vor der Abscheidung eine Plasmareinigung der Oberfläche des Wafers oder des Substrats erfolgt.

25. Verfahren nach einem der Ansprüche 22 bis 24,
**dadurch gekennzeichnet, dass** als Prozessgase Methan (CH₄) und Silan (SiH₄) verwendet werden.

26. Verfahren nach einem der Ansprüche 22 bis 25,
**dadurch gekennzeichnet, dass** über die Gasflüsse der Prozessgase CH₄ und SiH₄ die Stöchiometrie der Schichten und damit deren Funktion eingestellt wird.

27. Verwendung des Halbleiterbauelementes nach einem der Ansprüche 1 bis 21 als Solarzelle.

28. Verwendung des Halbleiterbauelementes nach einem der Ansprüche 1 bis 21 als Bestandteil von Sensoren oder optischen Filtern.

29. Verwendung mindestens einer Siliciumcarbid-Schicht als Reflektor in einem Halbleiterbauelement mit mindestens einer Halbleiterschicht und mindestens einer funktionalen Schicht, wobei die Brechungsindizes der funktionalen Schicht und der mindestens einen Siliciumcarbid-Schicht so aufeinander abgestimmt sind, dass über 60% des Lichts im Wellenlängenbereich größer 500 nm am Halbleiterbauelement reflektiert wird.

30. Verwendung nach Anspruch 29,
**dadurch gekennzeichnet, dass** die funktionale Schicht als Oberflächenpassivierung oder Diffusionsbarriere dient.

31. Verwendung nach einem der Ansprüche 29 oder 30,
**dadurch gekennzeichnet, dass** die Siliciumcarbid-Schicht aus amorphem Siliciumcarbid besteht.
